# EUROPEAN PATENT APPLICATION

(11) **EP 4 068 925 A1**
(43) Date of publication of application: **05.10.2022**
(21) Application number: 21306170.8
(22) Date of filing: 30.08.2021
(51) Int. Cl.: H05K 7/20, H05K 7/14

(54) **SCISSOR STRUCTURE FOR CABLE/TUBE MANAGEMENT OF RACK-MOUNTED LIQUID-COOLED ELECTRONIC ASSEMBLIES**

(30) Priority: 01.04.2021 EP 21305427
(71) Applicant: OVH, 59100 Roubaix (FR)
(72) Inventor: BAUCHART, Grégory Francis Louis, 59150 Wattrelos (FR); MENEBOO, Alexandre Alain Jean-Pierre, 62440 Harnes (FR); CHEHADE, Ali, 59283 Moncheaux (FR)
(74) Representative: BCF Global

(57) **Abstract**

The disclosed systems and structures are directed to the management of cable/tube bundles (114) for rack-mounted liquid-cooled cases (104) containing electronic assemblies (106). The management of cable/tube bundles (114) comprises an articulating scissor structure (112) containing a first arm (112A) detachably connected to a contact point (116) on a backplane (104B) of a rack-mounted immersion case (104), a second arm (112B) detachably connected to a contact point (118) on a backplane (102B) of a rack frame (102), and a joining portion (112C) connecting the first (112A) and second arms (112B). During the de-racking of the immersion case (104), the articulating scissor structure (112) is configured to laterally extend and support and guide the cable/tube bundle (114) across a de-racked space, and during the racking of the immersion case, the articulating scissor structure (112) is configured to laterally contract and guide the corresponding cable/tube bundle (114) into a fixed racked space.

## Description

### CROSS-REFERENCE TO RELATED APPLICATIONS

This application claims benefit to European Application No. EP 21305427, entitled "IMMERSION COOLING CONCEPTS FOR SERVERS", filed on April 1, 2021, the contents of which are incorporated by reference herein in their entirety.

### FIELD

The present disclosure generally relates to rack-mounted, liquid-cooled electronic equipment and, in particular, to the management of cables and flexible tubes servicing rack-mounted, liquid-cooled electronic equipment.

### BACKGROUND

Large computing facilities endeavor to keep up with the market demand for increased processing resources. Such facilities may, therefore, implement a large number of rack systems configured to support thousands or even tens of thousands of electronic processing assemblies to accommodate the market demand.

It will be appreciated that such a multitude of racked electronic processing assemblies consume large amounts of power and, in turn, generate substantial amounts of heat that needs to be controlled in order to ensure proper processing performance. Various heat mitigation measures, such as, for example, liquid-cooling techniques have been implemented to cool the racked electronic processing assemblies to acceptable ambient temperature levels.

Therefore, in addition to the power supply and communication cables, to and from each of the racked electronic processing assemblies, rack systems have to also accommodate related flexible liquid-cooling tubes. The combined cable and tube bundles for each of the serviced racked electronic processing assemblies frequently become unwieldly and difficult to manage during racking and de-racking maintenance operations. As such, there is an interest in managing the cable/tube bundles servicing racked liquid-cooled electronic assemblies.

### SUMMARY

The embodiments of the present disclosure have been designed based on the developers' appreciation of the limitations associated with the conventional cable/tube management of rack-mounted liquid-cooled electronic assemblies. In addressing such limitations, the embodiments of the present disclosure provide a rack system **(100)** for housing a plurality of rack-mounted immersion cases **(104)** that comprises a rack frame **(102)** configured to slidably accommodate individual racking and de-racking operations of each of the plurality of immersion cases **(104)** within the rack system **(100)** and an opening within the rack frame structure **(102)** configured to accommodate a plurality of cable/tube bundles **(114),** in which each one of the plurality of cable/tube bundles **(114)** individually service a corresponding one of the plurality of immersion cases **(104)** within the rack system **(100).**

The rack system **(100)** also comprises a plurality of articulating scissor structures **(112)** each comprising a first arm **(112A)** detachably connected to a contact point on the backplane of a corresponding immersion case **(104),** a second arm **(112B)** detachably connected to a contact point on a backplane of the rack frame, and a joining portion **(112C)** connecting the first and second arms. The plurality of articulating scissor structures **(112)** are configured to individually guide each one of the cable/tube bundles **(114)** along a racked space and a de-racked space, the racked and de-racked spaces being defined between a backplane of the corresponding immersion case and a backplane of the rack frame **(102),** in which the de-racked space is larger than the racked space.

The rack system **(100)** further enables, during the de-racking operation of an immersion case **(104),** the corresponding articulating scissor structure **(112)** is configured to laterally extend and guide the corresponding cable/tube bundle **(114)** across the de-racked space and, during the racking operation of an immersion case **(104),** the corresponding articulating scissor structure **(112)** is configured to laterally contract and guide the corresponding cable/tube bundle **(114)** within the racked space.

In certain implementations consistent with the present disclosure, each of the articulating scissor structures **(112)** further comprises a top portion of the first arm **(112A)** containing a fastener **(112D)** configured to detachably connect to the contact point on the backplane of the corresponding immersion case **(104);** a top portion of the second arm **(112B)** containing a fastener **(112E)** configured to detachably connect to a contact point on the backplane of the rack frame; and a bottom portion of the first arm **(112A)** and a bottom portion of the second arm **(112B)** that are connected by the joining portion **(112C).**

In certain implementations consistent with the present disclosure, each of the articulating scissor structures **(112)** further comprises a top portion of the first arm **(112A)** containing a fastener **(112D)** configured to detachably connect to the contact point on the backplane of the corresponding immersion case **(104);** a top portion of the second arm **(112B)** containing a fastener **(112E)** configured to detachably connect to a contact point on the backplane of the rack frame; and a bottom portion of the first arm **(112A)** and a bottom portion of the second arm **(112B)** that are connected by the joining portion **(112C).**

In certain implementations consistent with the present disclosure, during the de-racking operation of the immersion case **(104),** the first arm **(112A)** of the corresponding articulating scissor structure **(112)** is drawn away from the second arm **(112B)** thereby articulating the joining portion **(112C)** in an upward direction to extend the lateral distance between the backplanes of the corresponding immersion case **(104)** and the rack frame and guide the corresponding cable/tube bundle **(114)** across the de-racked space.

In certain implementations consistent with the present disclosure, during the racking operation of the immersion case **(104),** the first arm **(112A)** of the corresponding articulating scissor structure **(112)** is urged towards the second arm **(112B)** thereby articulating the joining portion **(112C)** in an downward direction to contract the lateral distance between the backplanes of the corresponding immersion case **(104)** and the rack frame and guide the corresponding cable/tube bundle **(114)** into the racked space.

### BRIEF DESCRIPTION OF THE FIGURES

Further features and advantages of the present disclosure will become apparent from the following detailed description taken in combination with the appended drawings, in which:
FIG. 1A is a cross-sectional view of an immersion case in a racked position serviced by the articulating scissor cable/tube management structure, in accordance with the embodiments of the present disclosure;
FIG. 1B is a perspective view of an immersion case in a racked position serviced by the articulating scissor cable/tube management structure, in accordance with the embodiments of the present disclosure;
FIG. 2A is a cross-sectional view of an immersion case in a de-racked position serviced by the articulating scissor cable/tube management structure, in accordance with the embodiments of the present disclosure;
FIG. 2B is a perspective view of an immersion case in a de-racked position serviced by the articulating scissor cable/tube management structure, in accordance with the embodiments of the present disclosure; and
FIG. 3 is a perspective view of the articulating scissor cable/tube management structure, in accordance with the embodiments of the present disclosure.

It is to be understood that throughout the appended drawings and corresponding descriptions, like features are identified by like reference characters and that the drawings are not to scale. It should also be understood that the drawings and ensuing descriptions are intended for illustrative purposes only and that such disclosures are not intended to limit the scope of the claims.

### DETAILED DESCRIPTION

The present disclosure is directed to addressing at least some of the limitations regarding conventional methods of managing the cable/tube bundles servicing rack-mounted liquid-cooled electronic assemblies.

It will be understood, however, that the examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology and are included within its spirit and scope.

Furthermore, as an aid to understanding, the following description may describe relatively simplified implementations of the present technology. As persons skilled in the art would understand, various implementations of the present technology may be of a greater complexity. In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology.

Moreover, where no examples of modifications have been set forth, it should not be interpreted that no modifications are possible and/or that what is described is the sole manner of implementing that element of the present technology. As such, all statements herein reciting principles, aspects, and implementations of the present technology, as well as specific examples thereof, are intended to encompass both structural and functional equivalents thereof, whether they are currently known or developed in the future.

It will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

Similarly, functions of the various elements shown in the figures, including any functional block labeled as a "processor", may be provided through the use of dedicated hardware as well as hardware capable of executing software in association with appropriate software.

With these fundamentals in place, presented heretofore are non-limiting embodiments that illustrate various aspects and implementations of the present disclosure.

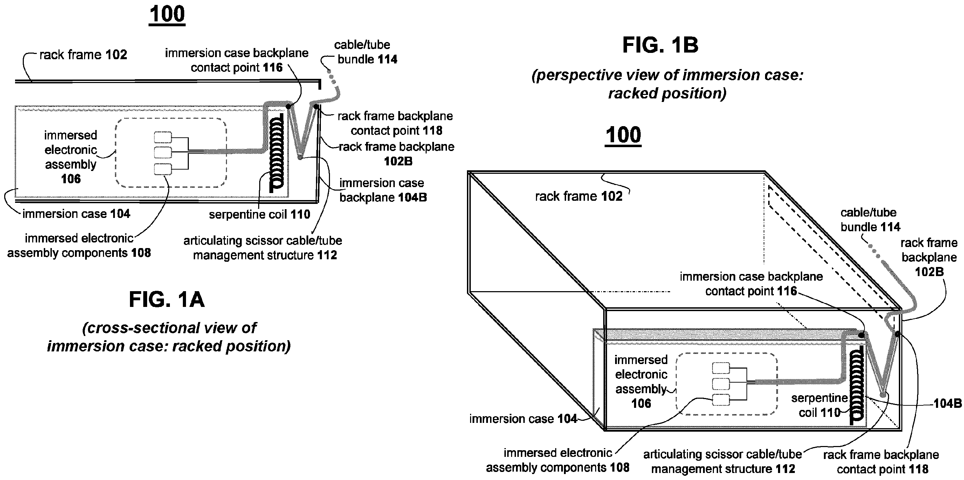

In particular, FIGs. 1A and 1B depict a cross-sectional view and perspective view, respectively, of a rack-mounted immersion case in a racked position serviced by the articulating scissor cable/tube management structure, in accordance with the embodiments of the present disclosure. The racked position of the immersion case 104 is applied during installation and real-time operations.

For illustrative purposes and ease of understanding only, the figures depict a single rack-mounted immersion case **104** within a rack system **100.** Such depictions should not be interpreted as being limiting, as the inventive concepts presented herein cover and contemplate the use of multiple immersion cases **104** housed by rack system **100.**

As shown, rack system **100** comprises a rack frame **102** that houses a rack-mounted, liquid-cooled casing **104** containing at least one electronic assembly **106.** As detailed below, the liquid cooling techniques employed to reduce the temperature of the at least one electronic assembly **106** or electronic components thereof, may comprise the use of an immersion dielectric cooling fluid, the use of circulated cooled channelized water to water blocks directly disposed on electronic components, or some combination of the two techniques. For tractability purposes, the description will refer to the rack-mounted, liquid-cooled casing as an immersion case **104** with the understanding that this term is not, in any way, intended to be limiting.

As depicted, immersion case **104** manifests a substantially "book-like" rectangular shape that, in the racked position, is slidably inserted and installed within rack frame **102** of rack system **100.** The immersion case **104** may be configured to contain at least one immersed electronic assembly **106** that is fully submerged in dielectric cooling fluid, in which the at least one immersed electronic assembly **106** contains various heat-generating processing components **108.**

In some implementations, immersion case **104** may be configured to contain a serpentine convection coil **110** immersed in the dielectric fluid. The serpentine convection coil **110** is configured to cool the ambient temperature of the dielectric cooling fluid caused by the heat-generating processing components **108** through thermal convection.

In some implementations, immersion case **104** may be configured to contain a closed-loop cooled water distribution arrangement configured to circulate cooled channelized water, via a flexible tube network, through serpentine convection coil **110** and through liquid cooling blocks that are directly thermally coupled to processing components **108.**

The cables that supply power and communication facilities to the immersed electronic processing assembly **106** along with the flexible tubes channeling cooled water are grouped together to form a cable/tube bundle **114** to service the corresponding immersion case **104.** The routing of cable/tube bundle **114** to the corresponding immersion case **104** is accommodated via an opening in rack frame **102.**

As shown, the backplane **104B** of immersion case **104** incorporates an immersion case contact point **116** and the backplane **102B** of the rack frame **102** incorporates a rack frame contact point **118.** As discussed in detail below, these contact points **116, 118** operate to engage complimentary elements of an articulating scissor cable/tube structure **112** that manages cable/tube bundle **114.** As such, immersion case contact point **116** and rack frame contact point **118** may comprise a protrusion, stud, stem, hole or similar elements to detachably mate with complimentary articulating scissor cable/tube structure **112** elements.

As also shown, while immersion case **104** is in the racked position, there exists a fixed lateral distance spacing between the backplane **104B** of immersion case **104** and the backplane **102B** of the rack frame **102.** This fixed lateral distance spacing defines a racked space. The racked space is configured to accommodate the housing of cable/tube bundle **114** of the corresponding immersion case **104** while in the racked position. In order to manage cable/tube bundle **114** of the corresponding immersion case **104,** articulating scissor cable/tube structure **112** is presented. The articulating scissor cable/tube structure **112** is configured to support and guide cable/tube bundle **114** into the racked space and maintain orderly control of cable/tube bundle **114.**

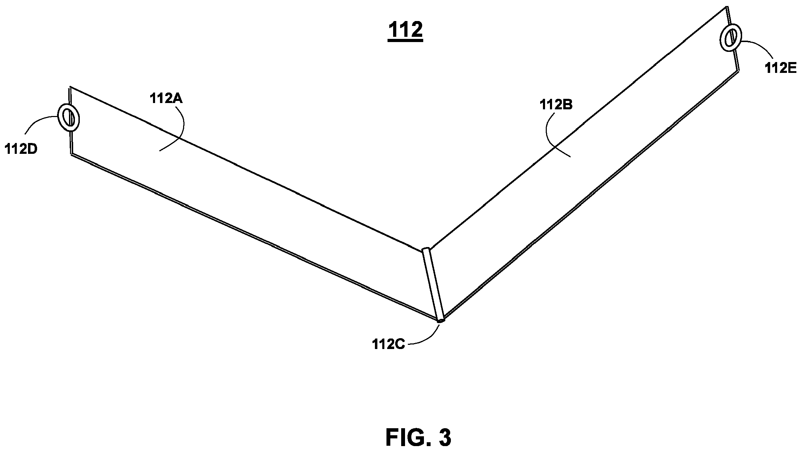

To this end, FIG. 3 depicts a perspective view of the articulating scissor cable/tube structure **112** features, in accordance with the embodiments of the present disclosure. As shown, articulating scissor cable/tube structure **112** comprises a first arm **112A,** a second arm **112B,** and a joining portion **112C** that couples first arm **112A** and second arm **112B** together. The joining portion **112C** is configured to couple first arm **112A** and second arm **112B** in a rotatable articulating manner, such as, for example, a hinge or flexible spring function.

The articulating scissor cable/tube structure **112** is designed to operate in a "scissor-like" manner, in which arms **112A, 112B** are configured to be capable of laterally extending outwardly apart from each other and causing joining portion **112C** to articulate in an upward direction. Commensurately, arms **112A, 112B** are also configured to be capable of laterally contracting inwardly towards each other and causing joining portion **112C** to articulate in a downward direction.

The articulating scissor cable/tube structure **112** may be constructed from a metal, plastic, rubber or any other suitable material. Moreover, articulating scissor cable/tube structure **112** may be constructed as a unitary component that is formed, pressed, or molded. Alternatively, articulating scissor cable/tube structure **112** may be constructed as an integrated assembly of individual components.

As depicted by FIG. 3, first arm **112A** incorporates a fastener **112D** disposed at a top portion thereof and is configured to detachably connect to or mate with immersion case backplane contact point **116.** The second arm **112B** incorporates a fastener **112E** disposed at a top portion thereof and is configured to detachably connect to or mate with rack frame backplane contact point **118.** The fasteners **112D, 112E** may comprise hook, catch, clasp, latch, clip, grommet, snap or other suitable components that may be easily attached to, and easily be detached from, the respective immersion case backplane contact point **116** and rack frame backplane contact point **118.**

Returning to FIGs. 1A, 1B, while the immersion case **104** is in the racked position, articulating scissor cable/tube structure **112** supports and guides cable/tube bundle **114** into the fixed racked space. Specifically, during racking operations, the first arm **112A** of articulating scissor cable/tube structure **112** that is engaged with immersion case backplane contact point **116** via fastener **112D** is urged towards second arm **112B** that is engaged with rack frame backplane contact point **118** via fastener **112E.** As a result, joining portion **112C** articulates in a downward direction to contract the lateral distance between the backplanes **102B, 104B** of the corresponding immersion case **104** and rack frame **102** to support and orderly guide cable/tube bundle **114** into the fixed racked space.

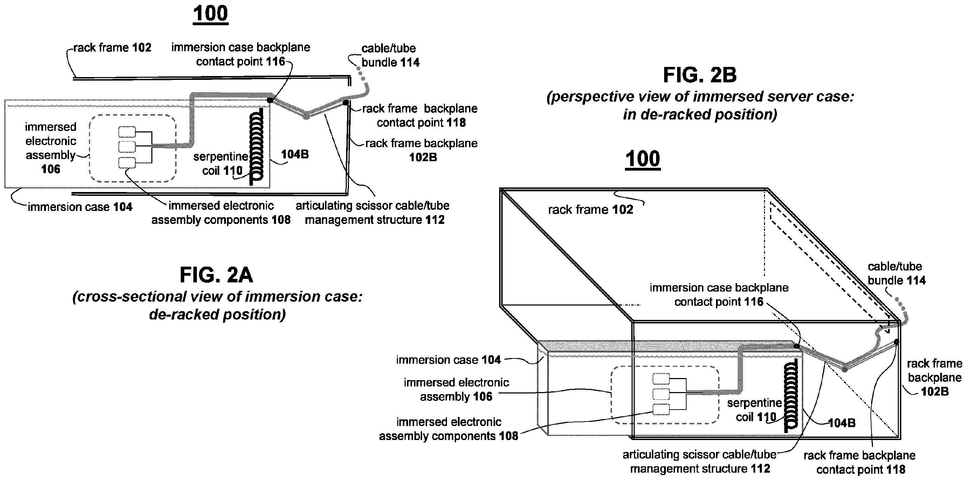

FIGs. 2A and 2B depict a cross-sectional view and perspective view, respectively, of a rack-mounted immersion case in a de-racked position serviced by the articulating scissor cable/tube management structure, in accordance with the embodiments of the present disclosure. The de-racked position of immersion case **104** applies during, for example, maintenance, repair, testing, *etc.* procedures. Because FIGs. 2A, 2B illustrate the same structural features as FIGs. 1A, 1B, identical reference characters are used and the previous descriptions of such features and attributes are omitted for purposes of brevity.

As depicted by FIGs. 2A, 2B, in the de-racked position, immersion case **104** is slidably extracted from rack frame **102.** In the de-racked position, the lateral distance spacing between the immersion case backplane **104B** and the rack frame backplane **102B** defines an adjustable de-racked space that is larger than the racked space. That is, the variability of the lateral distance spacing of the de-racked space is directly related to the extent to which immersion case **104** is slidably extracted from rack frame **102.**

As discussed above, articulating scissor cable/tube structure **112** is designed to operate in a "scissor-like" manner. Therefore, in de-racking operations, the first arm **112A** of articulating scissor cable/tube structure **112** that is engaged with immersion case backplane contact point **116** via fastener **112D** is drawn away from second arm **112B** that is engaged with rack frame backplane contact point **118** via fastener **112E.** As a result, joining portion **112C** articulates in an upward direction to extend the lateral distance spacing between the backplanes **104B, 102B** of the respective immersion case **104** and rack frame **102** to support and orderly guide cable/tube bundle **114** across the adjustable de-racked space.

In the event that an immersion case **104** has to be completely removed from rack frame **102** due to, for example, equipment malfunction/failure, upgrade replacement *etc.,* articulating scissor cable/tube structure **112** is configured to conveniently disengage from either the backplane of the corresponding immersion case **104** or from the backplane **102B** of rack frame **102.**

Specifically, as noted above, the first and second arms **112A, 112B** of articulating scissor cable/tube structure **112** incorporate fasteners **112D, 112E** that are configured to detachably connect to immersion case backplane contact point **116** and rack frame backplane contact point **118,** respectively. Accordingly, should complete removal of an immersion case **104** from rack frame **102** be necessary, either of the articulating scissor cable/tube structure fasteners **112D, 112E** may be easily and conveniently disengaged from the immersion case backplane contact point **116** and rack frame backplane contact point **118,** respectively, to facilitate complete removal of immersion case **104** from rack frame **102.**

It will also be understood that, although the embodiments presented herein have been described with reference to specific features and structures, various modifications and combinations may be made without departing from the underlying concepts and principles taught by these disclosures. As such, the specification and drawings are to be regarded as providing edifying guidance as to the underlying concepts and principles presented by the implementations and embodiments.

Accordingly, the scope encompassed by the underlying concepts and principles presented by the disclosed implementations and embodiments is defined by the appended claims, and are contemplated to cover any and all modifications, variations, combinations or equivalents that fall within the scope of the present disclosure.

## Claims

1. A rack system **(100)** for housing at least one rack-mounted, liquid-cooled case **(104)** containing at least one electronic assembly **(106),** comprising:
a rack frame **(102)** configured to slidably accommodate individual racking and de-racking operations of the at least one of liquid-cooled case **(104)** within the rack system **(100);**
an opening within the rack frame **(102)** configured to accommodate at least one cable/tube bundle **(114)** for individually servicing a corresponding at least one liquid-cooled case **(104)** within the rack system **(100);**
at least one articulating scissor structure **(112)** each comprising a first arm **(112A)** detachably connected to a contact point **(116)** on a backplane of a corresponding at least one liquid-cooled case **(104),** a second arm **(112B)** detachably connected to a contact point **(116)** on a backplane **(102B)** of the rack frame **(102),** and a joining portion **(118C)** connecting the first and second arms;
the at least one articulating scissor structure **(112)** configured to individually support and guide the at least one cable/tube bundle **(114)** along a racked space and a de-racked space, the racked and de-racked spaces being defined between the backplane of the corresponding at least one of liquid-cooled case **(104)** and the backplane **(102B)** of the rack frame **(102),** in which the de-racked space is larger than the racked space, wherein
the corresponding articulating scissor structure **(112)** is configured to laterally extend and guide the corresponding cable/tube bundle **(114)** across the de-racked space during the de-racking operation of the at least one of liquid-cooled case **(104),** and
the corresponding articulating scissor structure **(112)** is configured to laterally contract and guide the corresponding cable/tube bundle **(114)** into the racked space during the racking operation of the at least one of liquid-cooled case **(104).**

2. The rack system **(100)** of claim 1, wherein the at least one articulating scissor structure **(112)** further comprises:
atop portion of the first arm **(112A)** containing a fastener **(112D)** configured to detachably connect to the contact point **(116)** on the backplane of the corresponding at least one liquid-cooled case **(104);**
a top portion of the second arm **(112B)** containing a fastener **(112E)** configured to detachably connect to the contact point **(118)** on the backplane **(102B)** of the rack frame **(102);** and
a bottom portion of the first arm **(112A)** and a bottom portion of the second arm **(112B)** that are connected by the joining portion **(112C).**

3. The rack system **(100)** of claim 2, wherein the first arm fastener **(112D)** and the second arm fastener **(112E)** comprise a structure selected from the group consisting of: a hook, catch, clasp, latch, clip, grommet, and snap or any combination thereof.

4. The rack system **(100)** of any one of claims 1 to 3, wherein during the de-racking operation of the at least one liquid-cooled case **(104),** the first arm **(112A)** of the corresponding articulating scissor structure **(112)** is drawn away from the second arm **(112B)** thereby articulating the joining portion **(112C)** in an upward direction to extend the lateral distance between the backplanes of the corresponding at least one liquid-cooled case **(104)** and the rack frame **(102)** and support and guide the corresponding cable/tube bundle **(114)** across the de-racked space.

5. The rack system **(100)** of any one of claims 1 to 4, wherein during the racking operation of the at least one liquid-cooled case **(104),** the first arm **(112A)** of the corresponding articulating scissor structure **(112)** is urged towards the second arm **(112B)** thereby articulating the joining portion **(112C)** in a downward direction to contract the lateral distance between the backplanes of the corresponding at least one liquid-cooled case **(104)** and the rack frame **(102)** and support and guide the corresponding cable/tube bundle **(114)** into the racked space.

6. The rack system **(100)** of any one of claims 1 to 5, wherein the at least one liquid-cooled case **(104)** contains a volume of immersion dielectric cooling liquid for submerging the at least one electronic assembly **(106)** therein.

7. The rack system **(100)** of claim 5 further comprising a serpentine convection coil **(110)** configured to convey cooled channelized water to reduce ambient temperatures of the immersion dielectric cooling liquid.

8. The rack system **(100)** any one of the preceding claims, wherein the at least one liquid-cooled case **(104)** contains a closed-loop cooled water distribution arrangement configured to distribute channelized cooled water to one or more select components of the at least one electronic assembly **(106).**

9. The rack system **(100)** of any of the preceding claims, wherein the articulating scissor structure **(112)** is constructed from a material selected from the group consisting of: metal, plastic, and rubber material or any combination thereof.

10. The rack system **(100)** of any of the preceding claims, wherein the articulating scissor structure **(112)** comprises a unitary configuration that is formed, pressed, or molded.

11. The rack system **(100)** of any of the preceding claims, wherein the articulating scissor structure **(112)** comprises an assembled configuration integrating the first arm **(112A),** the second arm **(112B),** and the joining portion **(112C).**

12. The rack system **(100)** of any of the preceding claims, wherein the joining portion **(112C)** comprises a hinge or flexible spring structure.

13. The rack system **(100)** of any of the preceding claims, wherein the at least one liquid-cooled case **(104)** backplane contact point **(116)** comprises a structure selected from the group consisting of: a protrusion, stud, stem, and hole or any combination thereof.

14. A rack system **(100)** for housing a rack-mounted immersion case **(104),** comprising:
a rack frame **(102)** configured to slidably accommodate racking and de-racking operations of the immersion case **(104)** within the rack system **(100);**
an opening within the rack frame **(102)** configured to accommodate a cable/tube bundle **(114),** the cable/tube bundle **(114)** servicing the immersion case **(104)** within the rack system **(100);**
an articulating scissor structure **(112)** comprising a first arm **(112A)** detachably connected to a contact point **(116)** on a backplane of the immersion case **(104),** a second arm **(112B)** detachably connected to a contact point **(116)** on a backplane of the rack frame **(102),** and a joining portion **(118C)** connecting the first and second arms;
the articulating scissor structure **(112)** configured to individually support and guide the cable/tube bundle **(114)** along a racked space and a de-racked space, the racked and de-racked spaces being defined between the backplane of the immersion case **(104)** and the backplane of the rack frame **(102),** in which the de-racked space is larger than the racked space, wherein
the articulating scissor structure **(112)** is configured to laterally extend and guide the cable/tube bundle **(114)** across the de-racked space during the de-racking operation of the immersion case **(104),** and
the articulating scissor structure **(112)** is configured to laterally contract and guide the corresponding cable/tube bundle **(114)** into the racked space during the racking operation of the immersion case **(104).**

15. The rack system of claim 14, wherein
during the de-racking operation of the immersion case **(104),** the first arm **(112A)** of the articulating scissor structure **(112)** is drawn away from the second arm **(112B)** thereby articulating the joining portion **(112C)** in an upward direction to extend the lateral distance between the backplane of the immersion case **(104)** and the rack frame **(102)** to support and guide the cable/tube bundle **(114)** across the de-racked space, and
during the racking operation of the immersion case **(104),** the first arm **(112A)** of the articulating scissor structure **(112)** is urged towards the second arm **(112B)** thereby articulating the joining portion **(112C)** in an downward direction to contract the lateral distance between the backplane of the immersion case **(104)** and the rack frame **(102)** and support and guide the cable/tube bundle **(114)** into the racked space.
